**Europäisches Patentamt**

**European Patent Office**

**Office européen des brevets**

(11) Numéro de publication : **0 458 688 B1**

(12) **FASCICULE DE BREVET EUROPEEN**

(45) Date de publication du fascicule du brevet :
**05.04.95 Bulletin 95/14**

(51) Int. Cl.$^6$ : **H01L 31/0232**, G02B 6/42

(21) Numéro de dépôt : **91401285.1**

(22) Date de dépôt : **17.05.91**

(54) **Procédé de fabrication d'une structure intégrée guide-détecteur de lumière en matériau semi-conducteur.**

(30) Priorité : **21.05.90 FR 9006317**

(43) Date de publication de la demande :
**27.11.91 Bulletin 91/48**

(45) Mention de la délivrance du brevet :
**05.04.95 Bulletin 95/14**

(84) Etats contractants désignés :
**DE GB**

(56) Documents cités :
**ELECTRONICS LETTERS, vol. 25, no. 1, 5 janvier 1989, pages 35-37, Stevenage, Herts, GB; W. DÖLDISSEN et al.: "Butt coupled photodiodes integrated with Y-branched optical waveguides on InP"**
**ELECTRONICS LETTERS, vol. 23, no. 10, 7 mai 1987, pages 501-502, Stevenage, Herts, GB; S. CHANDRASEKHAR et al.: "Monolithic integrated waveguide photodetector"**
**ELECTRONICS LETTERS, vol. 23, no. 1, 2 janvier 1987, pages 2-4, Stevenage, Herts, GB; C. BORNHOLDT et al.: "Waveguide-integrated PIN photodiode on InP"**

(56) Documents cités :
**PROCEEDINGS OF THE 5TH EUROPEAN CONFERENCE ON INTEGRATED OPTICS, Paris, 26-28 avril 1989, vol. 1141, pages 14-18, SPIE, Bellingham, Washington, US; J.F. VINCHANT et al.: "Monolithic integration of short lenght photodetector with optical waveguide"**

(73) Titulaire : **FRANCE TELECOM Etablissement autonome de droit Public (Centre National d'Etudes des Télécommunications), 38/40 rue du Général Leclerc F-92131 Issy les Moulineaux (FR)**

(72) Inventeur : **Menigaux, Louis 85 Avenue des Tilleuls F-91440 Bures sur Yvette (FR)**
Inventeur : **Carenco, Alain 4 rue Paul Henri Thilloy F-92340 Bourg la Reine (FR)**
Inventeur : **Scavennec, André 8 rue Emile Deslandres F-75013 Paris (FR)**

(74) Mandataire : **Signore, Robert et al c/o BREVATOME 25, rue de Ponthieu F-75008 Paris (FR)**

EP 0 458 688 B1

## Description

La présente invention a pour objet un procédé de fabrication d'une structure intégrée monolithique guide-photodétecteur ou guide-photoconducteur en matériau semi-conducteur.

Cette structure est utilisable essentiellement dans le domaine de la télémétrie et des télécommunications optiques.

L'intégration élimine les défauts des circuits hybrides ; par exemple dans un circuit hybride à fibre optique, il est difficile d'ajuster à mieux que 1 mm, pour des débits supérieurs à 600 méga éléments binaires par seconde, les chemins optiques d'accès à une paire de photodiodes équilibrées, nécessaires à la réception cohérente hétérodyne ou homodyne.

Les premières structures intégrées monolithiques guide-photodétecteur ont été réalisées en technologie silicium. Dans cette technologie les guides de lumière sont réalisés en matériau diélectrique, généralement déposé sur $SiO_2$ et la détection est assurée par une diode réalisée dans le substrat. Une telle structure est décrite dans le document de D.B. Ostrowsky et al. "Integrated optical photodetector", Appl. Phys. Lett., vol. 22, n°9, mai 1973, P.463.

Cette solution n'est pas transposable aux structures semi-conductrices en matériau III-V ou II-VI puisque les guides en matériau semi-conducteur ont les mêmes domaines d'absorption et donc de transparence que le substrat.

Une structure mixte guide-photoconducteur en technologie couches diélectriques et matériau III-V a été décrite dans le document de J.C. Gammel et J.M. Ballantyne "An integrated photoconductive detector and waveguide structure", Appl. Phys. Lett. 36 (2), janvier 1980, p.149. Dans cette structure les guides optiques sont encore réalisés en matériau diélectrique et non en matériau semi-conducteur.

L'article de R. Trommer "Monolithic InGaAs photodiode array illuminated through an integrated waveguide", Electronics Letters vol.21, n° 9, avril 1985, p.82 rend compte du premier photodétecteur intégré à un guide optique à base de matériau III- V. Cette structure intégrée présente un certain nombre d'inconvénients.

En particulier la fabrication de cette structure nécessite deux épitaxies, une sur la face avant et une sur la face arrière, rendant complexe sa fabrication ; le faisceau lumineux à détecter traverse une couche épaisse d'InP n+ (200 micromètres environ) qui atténue une partie du faisceau du fait de l'absorption de ce dernier par les porteurs libres ; enfin, il faut faire coïncider une tranchée arrière en V avec le photodétecteur en face avant, ce qui présente des difficultés de réalisation importantes.

Un certain nombre de structures intégrées guide-photodétecteur en matériau III-V par couplage par ondes évanescentes a été envisagé (voir par exemple l'article de C.Bornholdt et al. "Waveguide - integrated p-i-n photodiode on InP", Electronics Letters, vol.23, n° 1, janvier 1987, p.2, ou l'article de S. Chandrasekhar et al. "Monolithic integrated waveguide photodetector", Electronics Letters, vol. 23, n° 10, mai 1987, p.501).

Dans l'état actuel des réalisations, les longueurs de couplage doivent être importantes, quelques centaines de micromètres, pour avoir des absorptions du faisceau lumineux, par la zone photodétectrice, supérieure à 90%. Il s'ensuit des dimensions de photodiodes importantes, d'où des impédances importantes et donc des vitesses de réponse réduites, ainsi que des courants d'obscurité plus élevés.

Différentes structures intégrées guide-photodétecteur en matériau III-V avec un couplage par le bout ont été envisagées, (voir en particulier le document de S. Chandrasekhar et al. "Integrated waveguide p-i-n photodetector by MOVPE regrowth", IEEE Electron device Letters, vol.EDL-8, n°11, novembre 1987, p.512). Dans ce type de structure, l'aire de diffusion p de la diode p-i-n doit être localisée avec beaucoup de précision par rapport à l'extrémité du guide optique (précision inférieure à 1 micromètre). C'est là le problème majeur du couplage par le bout.

De plus, une partie de la lumière à détecter peut passer en dehors de la couche absorbante et donc diminuer le rendement de la détection. En outre, la structure n'est pas planaire ; en conséquence la diffusion p sur le mésa entraîne un pincement de la zone intrinsèque au niveau du guide et donc un risque de claquage de la diode.

Dans l'article de W. Döldissen et al. ("Butt coupled photodiodes integrated with Y-branched optical waveguides on InP", Electronics Letters vol.25, n°1, janvier 1989, p.35), la détection en bout de la lumière est assurée par une diode obtenue par une diffusion p+ au-dessus de la couche guide, la surface de la diode est ensuite délimitée par attaque chimique sous forme de mésa. la jonction à nu est alors passivée par un diélectrique approprié. Cette technologie n'a jamais été la meilleure pour la tenue dans le temps de diode diffusée. Rien ne vaut, d'après les inventeurs, une diode planaire obtenue par diffusion localisée de dopant p dans une couche n.

L'invention a pour objet un procédé de fabrication d'une structure intégrée guide-photodétecteur ou guide-photoconducteur en matériau semi-conducteur permettant de remédier aux différents inconvénients donnés ci-dessus. En particulier, ce procédé est beaucoup plus simple à mettre en oeuvre que ceux de l'art antérieur et permet d'augmenter le rendement de la détection ; il offre en outre la possibilité d'utiliser des puissances optiques incidentes plus grandes.

Dans la suite de la description, le mot "détecteur" signifiera soit un photodétecteur (par exemple, diode p-i-n ou diode Schottky), soit un photoconducteur.

Dans la structure obtenue selon l'invention, le couplage du guide et du détecteur est assuré par le bout, et le procédé selon l'invention permet de relâcher les contraintes de précision liées à la localisation du détecteur par rapport à l'extrémité du guide.

De plus, le procédé permet de réaliser le détecteur aussi loin que possible des interfaces entre les zones absorbantes et transparentes à la lumière, limitant ainsi les pertes d'informations lumineuses.

De façon plus précise, l'invention a pour objet un procédé de fabrication d'une structure intégrée monolithique guide-détecteur, consistant à :

a) - épitaxier sur un matériau semi-conducteur une couche semi-conductrice inférieure de confinement puis une couche guide semi-conductrice et enfin une couche supérieure semi-conductrice de confinement, la couche guide intercalée entre les couches de confinement présentant une bande d'énergie interdite inférieure à celle desdites couches de confinement, ces couches ayant le même type de conductivité,

b) - graver la couche supérieure de confinement pour former un guide-ruban dont une extrémité définit une première contremarche,

c) - graver la couche guide dégagée lors de l'étape b pour former une seconde contremarche consécutive à la première contremarche,

d) - épitaxier une couche détectrice semiconductrice de ce type de conductivité sur la structure obtenue à l'étape c, la bande d'énergie interdite de cette couche détectrice étant inférieure à celle des couches de confinement et de la couche guide,

e) - éliminer la partie de la couche détectrice recouvrant le guide-ruban, et

f) - former le détecteur dans ladite couche détectrice, à proximité desdites contremarches de façon que le détecteur soit couplé en bout avec la couche guide ou à cheval sur la couche guide.

Grâce au palier ou contre marche de la couche guide, la partie détection n'est plus à localiser avec autant de précision que dans l'art antérieur, puisque le détecteur peut alors être à cheval sur l'extrémité de la couche guide.

Selon l'invention, la détection peut être une photodétection ou une photoconduction ; suivant le cas la couche détectrice est soit dénommée couche photodétectrice, soit couche photoconductrice.

La photodétection est réalisée en diffusant dans la couche détectrice des impuretés de conductivité différente de celle constituant les couches épitaxiées, de façon à constituer une jonction p-i-n. Un contact ohmique est en outre prévu sur les zones n et p.

La diffusion locale de ces ions dans la couche photodétectrice planaire permet de résoudre le problème de protection de la diode comme vu dans l'article de Döldissen cité précédemment.

Lorsque le détecteur est un photoconducteur, la diffusion d'ions et les contacts ohmiques sont remplacés par le dépôt de deux électrodes conductrices sur la couche détectrice, espacées l'une de l'autre et disposées en regard des contremarches de part et d'autre du guide-ruban ; ces deux électrodes sont parallèles au sens de propagation de la lumière dans le guide-ruban.

Dans la structure intégrée obtenue, la lumière est guidée dans la couche guide puis débouche dans la couche détectrice pour y être absorbée, ce qui provoque la conversion des photons en paires électron-trou dans la couche détectrice, située en sortie du guide-ruban, sous la zone diffusée ou sous les électrodes. Il en résulte un photocourant dans la diode p-i-n ou une variation de résistance aux bornes des électrodes du photoconducteur.

La distance séparant les contremarches doit être assez courte pour que l'absorption de lumière par ondes évanescentes dans la couche détectrice soit négligeable.

Avantageusement cette distance est supérieure ou égale à 5 µm et inférieure à 10 µm et par exemple égale 8 µm.

Le guide-ruban est relativement étroit, typiquement de 2 à 6 µm. Or, l'utilisation de guides de lumière aussi étroits en photodétection ou photoconduction fait que la densité d'énergie au niveau du photodétecteur ou du photoconducteur est très grande. Pour une section du guide typiquement de 5 µm², à mi-hauteur en intensité, une puissance lumineuse de 1 mW entrant dans le détecteur correspond à environ 20 kW/cm². (L'oscillateur local qui est utilisé dans un détecteur hétérodyne a effectivement une puissance optique de quelques mW).

La densité des photo-électrons est donc très forte et il en résulte au niveau du détecteur une dégénérescence du champ électrique existant dans la zone de charge d'espace de la zone diffusée ou de la zone située sous les électrodes selon que le détecteur est un photodétecteur ou un photoconducteur. Voir à ce sujet l'article de J.E. Viallet et al. "Photodiode for coherent detection : modeling and experimental results", Journal de Physique, Colloque C4, supplément au n°9, tome 49, septembre 1988, p. 321.

La conséquence est, d'une part une mauvaise collection des porteurs et donc une baisse du rendement photoélectrique et, d'autre part une augmentation de la capacité de la photodiode ou du photoconducteur entraînant une vitesse de réponse plus faible du détecteur.

L'invention propose de résoudre ce problème en laissant le faisceau de lumière s'épanouir librement par diffraction dans le plan des couches épitaxiées pour arriver à la largeur de la diode ou de l'espace inter-électrode, le guidage dans le plan perpendiculaire aux couches étant conservé.

A cet effet, le guide-ruban se termine à son extrémité en regard du détecteur par un élargissement latéral dans un plan parallèle aux couches épitaxiées. Ainsi, la densité d'énergie se trouve être diminuée au niveau du détecteur.

Le procédé conforme à l'invention s'applique à tout type de matériau semi-conducteur tel que les matériaux II-VI comme par exemple la famille des HgCdTe et à tout type de semi-conducteur III-V.

Le procédé de l'invention est parfaitement bien adapté aux composés III-V. Dans ce cas, les couches de confinement, la couche guide et la couche détectrice sont avantageusement non intentionnellement dopées pour limiter les phénomènes d'absorption lumineuse, le dopage résiduel étant généralement du type n- du fait de la mobilité plus élevée des porteurs majoritaires.

Selon un premier mode de réalisation, le substrat est en InP de type n+, les couches de confinement sont en InP de type n-, la couche guide est en $Ga_xIn_{1-x}As_yP_{1-y}$ de type n- avec $0<x\leq1$ et $0\leq y<1$ et la couche détectrice est en $Ga_{1-z}In_zAs$ de type n- avec $0\leq z\leq1$.

Selon un second mode de réalisation, le substrat est en GaAs de type n+, les couches de confinement sont en $Ga_{1-t}Al_tAs$ de type n- avec $0<t\leq1$, la couche guide est en GaAs de type n- et a couche détectrice en $Ga_{1-v}In_vAs$ de type n- avec $0<v\leq1$.

D'autres caractéristiques et avantages de l'invention ressortiront mieux de la description qui va suivre, donnée à titre illustratif et non limitatif, en référence aux dessins annexés, dans lesquels :

- les figures 1, 2A, 2B, 3, 4, 5A et 5B illustrent schématiquement les différentes étapes de fabrication d'une structure guide-photoconducteur, conforme à l'invention : les figures 1, 2A, 3, 4 et 5A sont des vues en coupe longitudinale et les figures 2B et 5B sont des vues de dessus ;
- les figures 2C, 6 et 7 sont des variantes de fabrication d'une structure intégrée guide-photodétecteur, conforme à l'invention : la figure 2C est une vue en coupe longitudinale et les figures 6 et 7 sont des vues de dessus ;
- la figure 8 illustre, en coupe longitudinale, la fabrication d'une structure intégrée guide-photodétecteur p-i-n conforme à l'invention, et
- la figure 9 montre, en coupe longitudinale, la fabrication d'une structure intégrée guide-photodétecteur, ne faisant pas partie de l'invention, montrant les difficultés pratiques d'un couplage en bout, sans réalisation d'une marche dans la couche guide.

Le procédé de l'invention étant parfaitement bien adapté aux matériaux III-V, la description qui suit se rapportera uniquement à ces matériaux.

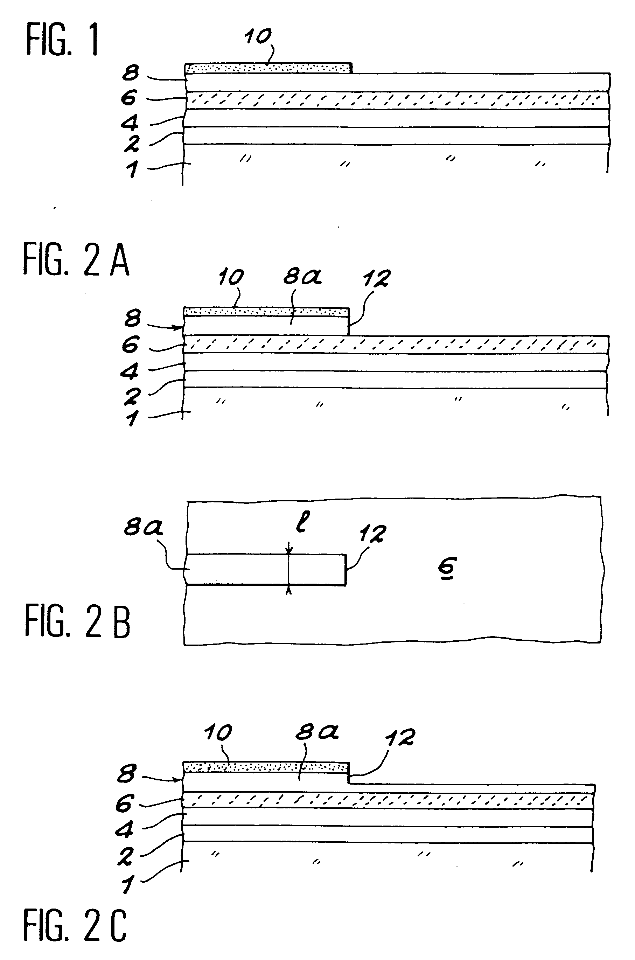

Le procédé selon l'invention comporte tout d'abord comme représenté sur la figure 1, une épitaxie des différentes couches semi-conductrices en matériau III-V sur un substrat monocristallin 1 en matériau III-V ; ces épitaxies sont réalisées indistinctement selon les techniques connues de MOCVD, LPE ou EJM.

Le substrat 1 est un substrat en matériau binaire InP ou GaAs, rendu semi-isolant par un dopage au chrome pour GaAs et au fer pour InP.

Sur le substrat 1, on épitaxie tout d'abord une couche tampon 2 semi-conductrice de même composition que le substrat, dopée n+ avec du silicium à une dose de $10^{18}at/cm^3$, de 1 µm d'épaisseur environ, ensuite une couche semi-conductrice inférieure 4 de confinement en matériau III-V non intentionnellement dopé, de 1µm d'épaisseur environ, puis une couche semi-conductrice guide 6 en matériau III-V non intentionnellement dopé, de 1 µm d'épaisseur environ, et enfin, une couche semi-conductrice supérieure 8 de confinement en matériau III-V non intentionnellement dopé de 1 µm d'épaisseur environ.

Les épaisseurs des couches sont choisies plus précisément en fonction des compositions exactes des matériaux et du taux de confinement optique souhaité.

Pour un substrat 1 et une couche tampon 2 en GaAs, les couches 4 et 8 de confinement sont en $Ga_{1-t}Al_tAs$ avec t choisi dans l'intervalle allant de 0,01 à 0,40 et la couche guide 6 est en GaAs. Pour un substrat 1 et une couche tampon 2 en InP, les couches de confinement 4 et 8 sont en InP et la couche guide est en $Ga_xIn_{1-x}As_yP_{1-y}$ avec la relation suivante entre x et y :

$$x = 0,1894\, y/(0,4184 - 0,013\, y)$$

de façon à assurer l'accord de maille sur InP. En outre, il est raisonnable de faire varier x et y dans une gamme où l'énergie de bande interdite de ce matériau quaternaire défini par la relation :

$$Eg\ (eV) = 1,35 - 0,72\, y + 0,12\, y^2$$

se situe entre 1,25eV (ou 1 µm) et 0,85eV (ou 1,45 µm), c'est-à-dire entre les couples de valeurs x=0,06 et y=0,14 d'une part, et x=0,37 et y=0,80 d'autre part.

Par une technique classique de photogravure (dépôt CVD, photomasque en résine, gravure chimique, élimination du photomasque), on réalise un masque 10 en nitrure de silicium ($Si_3N_4$) masquant la région de la couche de confinement 8 à conserver.

Par attaque sélective, on effectue une gravure de la couche 8, le nitrure 10 servant de masque à cette gravure, transférant ainsi la forme du masque 10 dans la couche 8, comme représenté sur les figures 2A et 2B. Cette gravure peut être réalisée par usinage ionique avec des ions d'argon ou par voie humide avec un mélange de $HCl/H_3PO_4$ en proportion 1 : 1 en volume pour une couche 8 en InP et avec $H_2SO_4/H_2O_2/H_2O$ en proportion 1:8:1 en volume pour une couche 8 en GaAlAs.

Le masque 10 se présente sous la forme d'un ruban de largeur donnée l s'étendant sur une partie seulement de la couche 8 ; il permet ainsi l'obtention d'un guide-ruban 8a de largeur l, typiquement de 4 micromètres (figure 2B) dont l'extrémité forme une contremarche 12 avec la couche 6.

La gravure de la couche 8 peut être réalisée sur toute son épaisseur, comme représenté sur la figure 2A ou bien sur une partie seulement de l'épaisseur de la couche, comme représenté sur la figure 2C.

On élimine ensuite le masque de gravure 10 par exemple par voie sèche avec un plasma de $CF_4$.

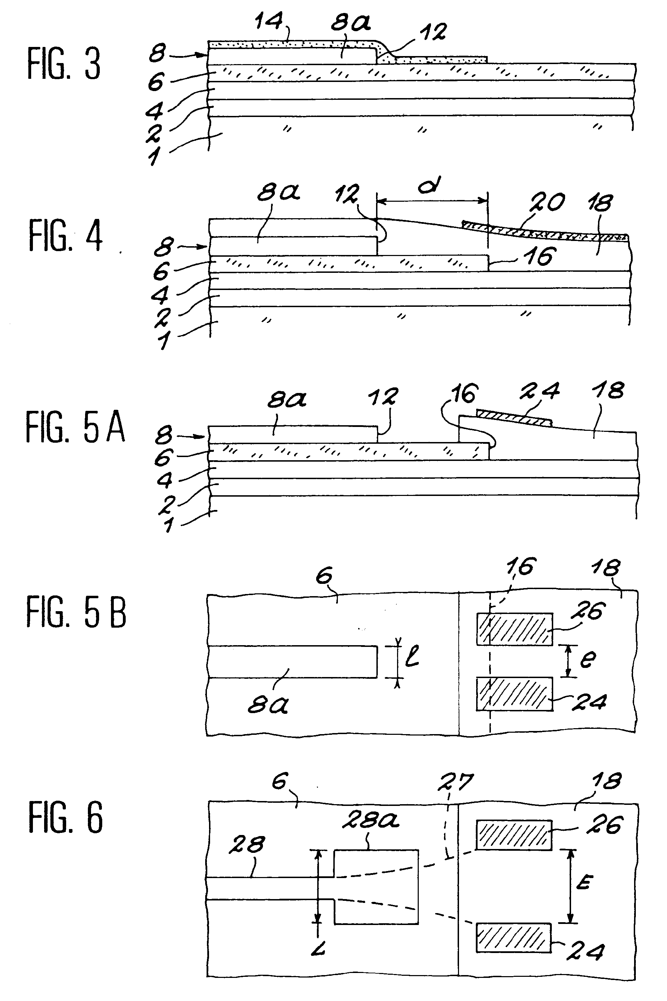

L'étape suivante du procédé, représenté sur la figure 3, consiste à former un nouveau masque 14 en nitrure de silicium destiné à masquer tout le guide-ruban 8a ainsi que les zones de la couche 6 destinées à être conservées. Ce masque 14 masque en particulier la zone de la couche 6, adjacente à la contremarche 12, située en bout de celle-ci.

On effectue alors une gravure sélective de la couche 6 sur toute son épaisseur. La structure obtenue est celle représentée sur la figure 4. La couche 6 gravée définit avec la couche 4 une contremarche 16, consécutive à la contremarche 12, de façon à constituer un escalier à deux marches.

Pour une couche 6 en GaInAsP l'attaque sélective peut être réalisée avec une solution de $H_2SO_4/H_2O_2/H_2O$ dans les proportions en volume 1:10:1 et pour une couche guide en GaAs la gravure peut être réalisée avec $CH_4O/H_2O_2/H_3PO_4$ en proportion 3:1:3 en volume.

La distance d séparant les deux contremarches est de 8 micromètres environ.

Après élimination du masque de gravure 14, dans les mêmes conditions que le masque 10, on effectue une épitaxie d'une couche semi-conductrice photoconductrice 18 en matériau III-V non intentionnellement dopé. Cette couche a une épaisseur supérieure à l'empilement des couches 8 et 6 et par exemple une épaisseur de 2 à 5 micromètres.

Cette couche 18 est réalisée en $Ga_{1-z}In_zAS$ de type n- ($<10^{16}$ cm$^{-3}$) avec z=0,47, ce qui correspond à une énergie de bande interdite de 0,75 eV (ou 1,65 µm), pour un substrat en InP ou en GaAs.

On forme un nouveau masque de nitrure de silicium 20 dont l'ouverture est pratiquée au-dessus des contremarches 12 et 16, l'extrémité de la couche 6 pouvant être masquée ou non. Le positionnement du masque n'est nullement critique.

On effectue alors une gravure sélective de la couche photoconductrice 18, de façon à en éliminer les parties non masquées de celle-ci. La structure obtenue est celle représentée sur la figure 5A. Cette gravure est réalisée par exemple par une solution de $H_2SO_4/H_2O_2/H_2O$ dans les proportions en volume 1:10:1.

On élimine ensuite le masque de gravure 20, comme décrit précédemment.

On effectue alors le dépôt de deux électrodes 24 et 26 sur la couche photoconductrice 18 par exemple par la technique "lift off" bien connue de l'homme de l'art.

Comme représenté sur la figure 5B, les électrodes 24 et 26 sont disposées dans le prolongement du guide-ruban 8a et disposées de façon symétrique de part et d'autre de ce dernier ; elles sont orientées parallèlement à l'axe longitudinal du guide-ruban 8a. Ces électrodes peuvent être à cheval ou non sur la couche 6.

La distance e séparant les deux électrodes est voisine de la largeur l du guide-ruban 8a.

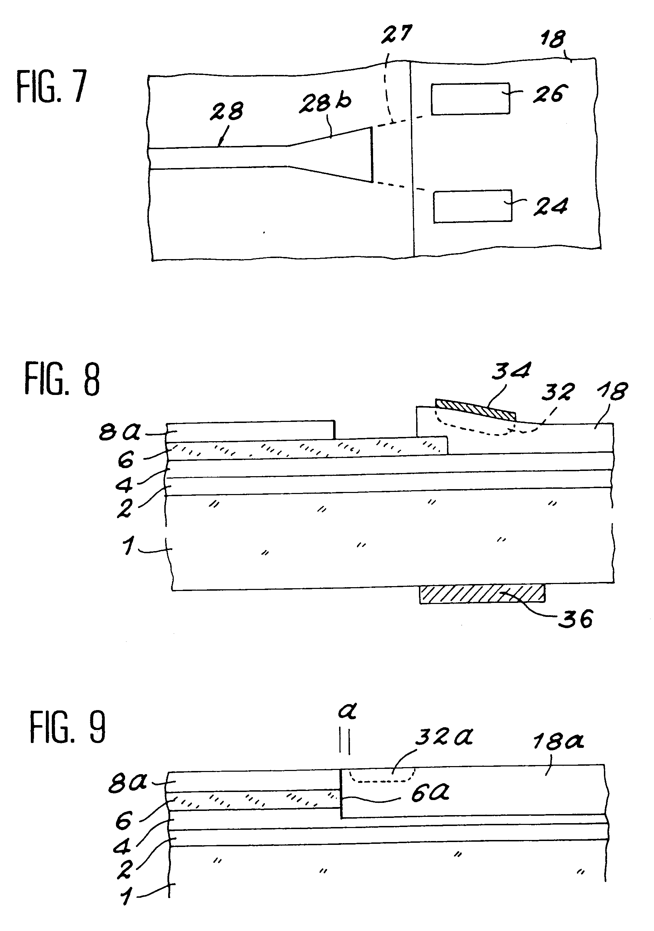

Une façon d'augmenter la puissance optique incidente détectable avec le rendement photoélectrique ainsi que la vitesse de réponse optimum, est de laisser s'épanouir librement, par diffraction dans le plan des couches épitaxiées, le faisceau de lumière 27, comme cela est représenté sur les figures 6 et 7.

A cet effet, le guide-ruban 28 défini dans la couche 8 se termine, à son extrémité en regard des électrodes 24 et 26, par un élargissement latéral 28a ou 28b dans un plan parallèle aux couches épitaxiées, le guidage dans le plan perpendiculaire aux couches étant conservé.

Cette partie élargie peut présenter la forme d'un parallélépipède rectangle 28a, comme représenté sur la figure 6, ou bien la forme d'un tronc de cône 28b, comme représenté sur la figure 7 ou toute autre forme adiabatique (parabolique par exemple). Ces configurations particulières du guide-ruban sont obtenues au cours de la gravure sélective de la couche 8, en utilisant un masque de gravure de forme appropriée.

Dans la configuration de la figure 6, la distance E séparant les électrodes 24 et 26 est égale à la largeur L de la partie élargie 28a, mesurée selon une direction perpendiculaire à la propagation du faisceau 27.

La partie détecteur de la structure intégrée de l'invention peut aussi consister en un photodétecteur, comme représenté sur la figure 8. Cette structure ne se différencie de la précédente que par la partie détection. Cette dernière consiste à remplacer les deux électrodes 24 et 26 par une zone diffusée 32 de conductivité inverse de celle de la couche détectrice 18 et en particulier une zone diffusée p+. Cette zone diffusée 32 est située à cheval sur l'extrémité de la couche guide.

Cette diffusion est réalisée à travers un masque de nitrure de silicium dont l'ouverture est située à l'aplomb de la contremarche 16. Cette ouverture a un diamètre d'environ 30 micromètres. Une diffusion localisée de $ZnAs_2$ en ampoule scellée est effectuée dans les conditions suivantes : 2 heures à 500°C pour une profondeur de jonction d'environ 1,5 micromètre.

Cette diffusion p+ est réalisée en particulier avant d'éliminer la partie de la couche 18 située au-dessus de la partie guidante de la structure (figures 4 et 5A).

Des contacts ohmiques 34 et 36 sont réalisés respectivement sur les zones p+ et n+ de la diode. Ils sont respectivement en AuZn et AuGeNi.

Le guide-ruban de cette structure guide-photodétecteur peut bien entendu comporter une partie élargie, comme représenté sur les figures 6 et 7, la largeur L de la partie élargie étant environ égale au diamètre de la diode soit 30 micromètres.

La réalisation de la photodiode ou du photoconducteur aussi loin que possible des interfaces de croissance de la couche 18 permet de limiter les pertes d'informations lumineuses et donc d'augmenter le rendement de la photodiode ou du photoconducteur. En effet les interfaces de croissance sont des pièges pour les électrons engendrés par illumination.

Dans le couplage par le bout d'un guide et d'un photodétecteur, la jonction pn doit être situé au ras de la limite du guide, comme représenté sur la figure 9 ; la distance a séparant l'extrémité 6a du guide et la zone diffusée 32 de la jonction peut varier de 1 à quelques micromètres selon la qualité absorbante du matériau photodétecteur 18a. Or, il est très difficile en pratique de réduire au maximum la distance a.

Avec l'idée du palier sur la couche guide, conformément à l'invention, la partie détection et notamment la zone diffusée 32 ou les électrodes 24 et 26 n'ont plus besoin d'être localisées avec précision.

## Revendications

1. Procédé de fabrication d'une structure intégrée monolithique guide-détecteur, consistant à :

   a) - épitaxier sur un matériau semi-conducteur (2, 1) une couche semi-conductrice inférieure de confinement (4) puis une couche guide semi-conductrice (6) et enfin une couche supérieure semi-conductrice de confinement (8), la couche guide (6) intercalée entre les couches de confinement présentant une bande d'énergie interdite inférieure à celles desdites couches de confinement (4, 8), ces couches ayant le même type de conductivité,

   b) - graver la couche supérieure de confinement (8) pour former un guide-ruban (8a, 28) dont une extrémité définit une première contremarche (12),

   c) - graver la couche guide (6) dégagée lors de l'étape b pour former une seconde contremarche (16) consécutive à la première contremarche (12),

   d) - épitaxier une couche semi-conductrice détectrice (18) de ce type de conductivité sur la structure obtenue à l'étape c, la bande d'énergie interdite de cette couche détectrice étant inférieure à celle des couches de confinement (4, 8) et de la couche guide (6),

   e) - éliminer la partie de la couche détectrice (18) recouvrant le guide-ruban (8a, 28), et

   f) - former le détecteur dans ladite couche détectrice (18), à proximité desdites contremarche (12, 16) de façon que le détecteur soit couplé en bout avec la couche guide (6) ou à cheval sur la couche guide (6).

2. Procédé selon la revendication 1, caractérisé en ce que la gravure de la couche supérieure de confinement (8) est réalisée, sur une partie seulement de son épaisseur, de façon à ce qu'il subsiste du matériau semi-conducteur de cette couche supérieure sur la couche guide (6).

3. Procédé selon la revendication 1 ou 2, caractérisé en ce que le guide-ruban (28) se termine à ladite extrémité par un élargissement latéral (28a) dans un plan parallèle aux couches épitaxiées.

4. Procédé selon l'une quelconque des revendications 1 à 3, caractérisé en ce que l'étape f consiste à former deux électrodes conductrices (24, 26) sur la couche détectrice (18), espacées l'une de l'autre et disposées en regard des contremarches (12, 16) de part et d'autre du guide-ruban (8a, 28) et parallèlement à ce dernier.

5. Procédé selon l'une quelconque des revendications 1 à 3, caractérisé en ce que l'étape f consiste à faire diffuser localement des impuretés (32) d'un type de conductivité différent de celui de la couche semi-conductrice détectrice (18) pour former en regard des contremarches (12, 16) une jonction pn et à former un contact ohmique (34, 36) sur chacune des zones n et p.

6. Procédé selon l'une quelconque des revendications 1 à 5, caractérisé en ce que la distance (d) séparant les contremarches (12, 16) est choisie dans l'intervalle allant de 5 à 10 micromètres.

7. Procédé selon l'une quelconque des revendications précédentes, caractérisé en ce que le matériau semi-conducteur supportant les couches épitaxiées est constitué d'un substrat semi-isolant (1) sur lequel on a épitaxié une couche semi-conductrice (2) fortement dopée et dont la conductivité est du même type que celle constituant les couches inférieure et supérieure de confinement (4, 8), la couche guide (6) et la couche détectrice (18).

8. Procédé selon l'une quelconque des revendications précédentes, caractérisé en ce que le matériau semi-conducteur (1, 2) et les couches semiconductrices (4, 6, 8, 18) sont constitués de composés III-V.

9. Procédé selon la revendication 7 ou 8, caractérisé en ce que les couches de confinement (4, 8), la couche guide (6) et la couche détectrice (18) sont non intentionnellement dopées.

10. Procédé selon l'une quelconque des revendications 7 à 9, caractérisé en ce que le substrat (1) est en InP de type n+, les couches de confinement (4, 8) sont en InP de type n-, la couche guide (6) est en $Ga_xIn_{1-x}As_yP_{1-y}$ de type n- avec $0<x\leqq1$ et $0\leqq y<1$ et la couche détectrice (18) est en $Ga_{1-z}In_zAs$ de type n- avec $0\leqq z\leqq1$.

11. Procédé selon l'une quelconque des revendications 7 à 9, caractérisé en ce que le substrat (1) est en GaAs de type n+, les couches de confinement (4, 8) sont en $Ga_{1-t}Al_tAs$ de type n- avec $0<t\leqq1$, la couche guide (6) est en GaAs de type n- et la couche détectrice (18) en $Ga_{1-v}In_vAS$ de type n- avec $0<v\leqq1$.

**Patentansprüche**

1. Herstellungsverfahren einer monolithischen, integrierten Leiter-Detektor-Struktur, bestehend im :

   a) Epitaxieren einer unteren Halbleitergrenzschicht (4) auf einem Halbleitermaterial (2, 1), sodann einer Halbleiter-Leitschicht (6) und schließlich einer oberen Halbleitergrenzschicht (8), wobei die zwischen die Grenzschichten eingefügte Leitschicht (6) ein verbotenes Energieband aufweist, das kleiner ist als das der genannten Grenzschichten (4, 8), wobei diese Schichten denselben Konduktivitätstyp haben,

   b) Ätzen der oberen Grenzschicht (8), um einen Leitstreifen (8a, 28) zu bilden, dessen eines Ende eine erste Steigung bzw. Stufe (12) bildet,

   c) Ätzen der während Schritt $\underline{b}$ freigelegten Leitschicht (6), um eine zweite, auf die erste Stufe (12) folgende Stufe (16) zu bilden,

   d) Epitaxieren einer Halbleiterdetektorschicht (18) von diesem Konduktivitätstyp auf der in Schritt $\underline{c}$ erhaltenen Struktur, wobei das verbotene Energieband dieser Detektorschicht kleiner ist als das der Grenzschichten (4, 8) und der Leitschicht (6),

   e) Beseitigen des Teils der Detektorschicht (18), der den Leitstreifen (8a, 28) bedeckt, und

   f) Bilden des Detektors in der Detektorschicht (18) in der Nähe der genannten Stufen (12, 16), so daß der Detektor durch das Endstück mit der Leitschicht (6) oder rittlings auf der Leitschicht (6) sitzend gekoppelt ist.

2. Verfahren nach Anspruch 1, dadurch gekennzeichnet, daß das Ätzen der oberen Grenzschicht (8) nur über einen Teil ihrer Dicke durchgeführt wird, so daß Halbleitermaterial dieser oberen Schicht zurückbleibt auf der Leitschicht (6).

3. Verfahren nach Anspruch 1 oder 2, dadurch gekennzeichnet, daß der Leitstreifen (28) an dem genannten Ende endet durch eine seitliche Verbreiterung (28a) in einer zu den epitaxierten Schichten parallelen Ebene.

4. Verfahren nach einem der Ansprüche 1 bis 3, dadurch gekennzeichnet, daß der Schritt $\underline{f}$ darin besteht, zwei leitende Elektroden (24, 26) zu bilden auf der Detektorschicht (18), beabstandet voneinander und den Stufen (12, 16) gegenüberstehend angeordnet, beiderseits des Streifenleiters (8a, 28) und parallel zu diesem letzteren.

5. Verfahren nach einem der Ansprüche 1 bis 3, dadurch gekennzeichnet, daß der Schritt $\underline{f}$ darin besteht, lokal Verunreinigungen bzw. Fremdatome (32) eines Konduktivitätstyps zu diffundieren, der sich unterscheidet von dem der Halbleiter-Detektorschicht (18), um den Stufen (12, 16) gegenüber einen PN-Übergang zu bilden und einen ohmschen Kontakt (34, 36) auf jeder der N- und P-Zonen herzustellen.

6. Verfahren nach einem der Ansprüche 1 bis 5, dadurch gekennzeichnet, daß der Abstand (d), der die Stufen (12, 16) trennt gewählt wird in dem Bereich von 5 bis 10 Mikrometer.

7. Verfahren nach einem der vorhergehenden Ansprüche, dadurch gekennzeichnet, daß das Halbleitermaterial, das die epitaxierten Schichten trägt, gebildet wird durch ein halbisolierendes Substrat (1), auf das man eine stark dotierte Halbleiterschicht (2) epitaxiert hat, deren Konduktivität von demselben Typ ist wie die der oberen und der unteren Grenzschicht (4, 8), der Leitschicht (6) und der Detektorschicht (18).

8. Verfahren nach einem der vorhergehenden Ansprüche, dadurch gekennzeichnet, daß das Halbleitermaterial (1, 2) und die Halbleiterschichten (4, 6, 8, 18) gebildet werden durch III-V-Verbindungen.

9. Verfahren nach Anspruch 7 oder 8, dadurch gekennzeichnet, daß die Grenzschichten (4, 8), die Leitschicht (6) und die Detektorschicht (18) unbeabsichtigt dotiert sind.

10. Verfahren nach einem der Ansprüche 7 bis 9, dadurch gekennzeichnet, daß das Substrat (1) aus InP des Typs n+ ist, die Grenzschichten (4, 8) aus InP des Typs n- sind, die Leitschicht (6) aus $Ga_xIn_{1-x}As_yP_{1-y}$ des Typs n- mit $0<x\leqq1$ und $0\leqq y<1$ ist, und die Detektorschicht (18) aus $Ga_{1-z}In_zAs$ des Typs n- mit $0\leqq z\leqq1$ ist.

11. Verfahren nach einem der Ansprüche 7 bis 9, dadurch gekennzeichnet, daß das Substrat (1) aus GaAs des Typs n+ ist, die Grenzschichten (4, 8) aus $Ga_{1-t}Al_tAs$ des Typs n- mit $0<x\leqq1$ sind, die Leitschicht (6) aus GaAs des Typs n- ist, und die Detektorschicht (18) aus $Ga_{1-v}In_vAs$ des Typs n- mit $0<v\leqq1$ ist.

## Claims

1. Method for producing an integrated monolithic detector-guide structure consisting of:

   a) epitaxially growing on a semiconductive material (2, 1) a lower semiconductive confinement film (4) followed by a semiconductive guide film (6) and finally an upper semiconductive confinement film (8), the guide film (6) being inserted between the confinement films having a forbidden energy band smaller than those of said confinement films (4, 8), said films having the same type of conductivity,

   b) etching the upper confinement film (8) so as to form a strip guide (8a, 28) with one extremity defining a first step (12),

   c) etching the guide film (6) freed during stage b) so as to form a second step (16) adjacent to the first step (12),

   d) epitaxially growing a semiconductive detector film (18) with this type of conductivity on the structure obtained in stage c), the forbidden energy band of this detector film being smaller than that of the confinement films (4, 8) and guide film (6).

   e) eliminating that portion of the detector film (18) covering the strip guide (8a, 28), and

   f) forming the detector in said detector film (18) in the vicinity of said steps (12, 16) so that the detector is butt coupled with the guide film (6) or astride the guide film (6).

2. Method according to claim 1, characterized in that the etching of the upper confinement film (8) is performed solely on one portion of its thickness so that the semi-conductive material of this upper film remains on the guide film (6).

3. Method according to claim 1 or 2, characterized in that the strip guide (28) ends at said extremity by a lateral widening (28a) in a plane parallel to the epitaxied films.

4. Method according to any one of the claims 1 to 3, characterized in that the stage f) consists of forming two conductive electrodes (24, 26) on the detector film (18) spaced from each other and disposed opposite the steps (12, 16) on both sides of the strip guide (8a, 28) and parallel to the latter.

5. Method according to any one of the claims 1 to 3, characterized in that the stage f) consists of locally diffusing impurities (32) having a type of conductivity differing from that of the detecting semiconductive film (18) so as to form opposite the steps (12, 16) a pn junction and an ohmic contact on each of the zones n and p.

6. Method according to any one of the claims 1 to 5, characterized in that the distance (d) separating the vertical flanks of the first and second steps (12, 16) is selected in the range from 5 to 10 micrometres.

7. Method according to any one of the preceding claims, characterized in that the semiconductive material supporting the epitaxied films is constituted by a semi-nonconductive substrate (1), on which a highly doped semiconductive film (2) has been epitaxied and whose conductivity is of the same type as that constituting the upper and lower confinement films (4, 8), the guide film (6) and the detector film (18).

8. Method according to any one of the preceding claims, characterized in that the semiconductive material (1, 2) and the semiconductive films (4, 6, 8, 18) are constituted by III-V compounds.

9. Method according to claim 7 or 8, characterized in that the confinement films (4, 8), the guide film (6) and the detector film (18) are not deliberately doped.

10. Method according to any one of the claims 7 to 9, characterized in that the substrate (1) is of $n^+$ InP, the confinement films (4, 8) are $n^-$ InP films, the guide film (6) is a $n^-$ $Ga_xIn_{1-x}As_yP_{1-y}$ film, $n^-$, with $0<x\leqq1$ and $0\leqq y<1$, and the detector film (18) is a $n^-$ $Ga_{1-z}In_zAs$ film, with $0\leqq z\leqq1$.

11. Method according to any one of the claims 7 to 9, characterized in that the substrate (1) is a $n^+$ GaAs substrate, the confinement films (4, 8) are $n^-$ $Ga_{1-t}Al_tAs$ films, with $0<t\leqq1$, the guide film (6) is a $n^-$ GaAs film, and the detector film (18) is a $n^-$ $Ga_{1-v}In_vAs$ film, with $0<v\leqq1$.

FIG. 1

FIG. 2 A

FIG. 2 B

FIG. 2 C

FIG. 3

FIG. 4

FIG. 5 A

FIG. 5 B

FIG. 6

FIG. 7

FIG. 8

FIG. 9